# EUROPEAN PATENT APPLICATION

(11) **EP 2 314 738 A1**
(43) Date of publication of application: **27.04.2011**
(21) Application number: 09773382.8
(22) Date of filing: 25.06.2009
(51) Int. Cl.: C30B 29/38, C30B 23/06, G02B 1/02

(54) **PROCESS FOR PRODUCTION OF A AlxGa(1-X)N SINGLE CRISTAL, AlxGa(1-X)N SINGEL CRISTAL, AND OPTICS**

(30) Priority: 01.07.2008 JP 2008172563
(71) Applicant: Sumitomo Electric Industries, Ltd., Chuo-ku Osaka-shi Osaka 541-0041 (JP)
(72) Inventor: ARAKAWA, Satoshi, Itami-shi Hyogo 664-0016 (JP); SAKURADA, Takashi, Itami-shi Hyogo 664-0016 (JP); YAMAMOTO, Yoshiyuki, Itami-shi Hyogo 664-0016 (JP); SATOH, Issei, Itami-shi Hyogo 664-0016 (JP); TANIZAKI, Keisuke, Itami-shi Hyogo 664-0016 (JP); NAKAHATA, Hideaki, Itami-shi Hyogo 664-0016 (JP); MIZUHARA, Naho, Itami-shi Hyogo 664-0016 (JP); MIYANAGA, Michimasa, Osaka-shi Osaka 554-0024 (JP)
(74) Representative: Grünecker, Kinkeldey, Stockmair & Schwanhäusser Anwaltssozietät
(86) International application number: PCT/JP2009/061612
(87) International publication number: WO 2010/001804

(57) **Abstract**

A method of producing an AlₓGa₍₁₋ₓ₎N (0 < x ≤ 1) single crystal (10) is directed to growing an AlₓGa₍₁₋ₓ₎N single crystal (10) by sublimation. The method includes the steps of preparing an underlying substrate having a composition ratio x identical to the composition ratio of the AlₓGa₍₁₋ₓ₎N single crystal, preparing a raw material of high purity, and growing an AlₓGa₍₁₋ₓ₎N single crystal (10) on the underlying substrate by sublimating the raw material. The AlₓGa₍₁₋ₓ₎N single crystal (10) has an absorption coefficient less than or equal to 100 cm⁻¹ with respect to light at a wavelength greater than or equal to 250 nm and less than 300 nm, and an absorption coefficient less than or equal to 21 cm⁻¹ with respect to light at a wavelength greater than or equal to 300 nm and less than 350 nm.

## Description

### TECHNICAL FIELD

The present invention relates to an AlₓGa₍₁₋ₓ₎N single crystal, a method of producing an AlₓGa₍₁₋ₓ₎N single crystal, and an optical component.

### BACKGROUND ART

The window member of a light emitting device such as an LED (Light Emitting Diode) and LD (Laser Diode) in the ultraviolet range to deep ultraviolet range (250 nm to 350 nm) using nitride semiconductor, employed in arc tubes of high-pressure discharge lamps, as disclosed in Japanese Patent Laying-Open No. 2007-070218 (Patent Document 1), in sterilization and medical treatment, biochips, as well as high density DVDs of the next generation requires transparency to light in the range from ultraviolet to deep ultraviolet.

As a material having transparency in the wavelength region set forth above, the aforementioned Patent Document 1, Japanese Patent Laying-Open No. 60-193254 (Patent Document 2), Japanese Patent Laying-Open No.2005-119953 (Patent Document 3), and Japanese Patent Laying-Open No. 2005-166454 (Patent Document 4) teach the usage of an AlN (aluminium nitride) sintered compact.

Further, Japanese Patent Laying-Open No. 2000-121801 (Patent Document 5) and Japanese Patent Laying-Open No. 2006-044982 (Patent Document 6) teach the usage of an AlN single crystal for the aforementioned material. The AlN single crystal of Patent Document 5 is grown on a substrate of another type by sputtering. The AlN single crystal of Patent Document 6 is grown by HVPE (Hydride Vapor Phase Epitaxy).

In addition, Japanese Patent Laying-Open No 6-265701 (Patent Document 7) teaches the usage of an AlN film for the aforementioned material. The AlN film of Patent Document 7 is grown on a glass substrate.

### PRIOR ART DOCUMENTS

### PATENT DOCUMENTS

Patent Document 1: Japanese Patent Laying-Open No. 2007-070218
Patent Document 2: Japanese Patent Laying-Open No. 60-193254
Patent Document 3: Japanese Patent Laying-Open No. 2005-119953
Patent Document 4: Japanese Patent Laying-Open No. 2005-166454
Patent Document 5: Japanese Patent Laying-Open No. 2000-121801
Patent Document 6: Japanese Patent Laying-Open No. 2006-044982
Patent Document 7: Japanese Patent Laying-Open No. 6-265701

### SUMMARY OF THE INVENTION

### PROBLEMS TO BE SOLVED BY THE INVENTION

The AlN sintered compact disclosed in Patent Documents 1-4 often has a crystal defect. Moreover, the oxygen concentration in the AlN sintered body is high since sintering aids such as Al₂O₃ (sapphire), Y₂O₅ (yttrium oxide) and CaO₂ (calcium peroxide) are employed. Moreover, it is difficult to render the surface flat since chaffing will occur during polishing the surface of the AlN sintered compact. Therefore, there was a problem that transparency to light at the wavelength in the ultraviolet range to the deep ultraviolet range is not sufficient.

The AlN single crystal of Patent Documents 5 and 6 as well as the AlN film of Patent Document 7 are oriented films, as appreciated from the production method thereof This means that light will be reflected at the surface, leading to the problem that transparency to light at the wavelength from the ultraviolet range to deep ultraviolet range is not sufficient.

Therefore, the present invention provides an AlₓGa₍₁₋ₓ₎N single crystal having improved transparency in the ultraviolet range to deep ultraviolet range, a method of producing an AlₓGa₍₁₋ₓ₎N single crystal, and an optical component.

### MEANS FOR SOLVING THE PROBLEMS

The inventors of the present invention directed their attention to an AlₓGa₍₁₋ₓ₎N (0 < x ≤ 1) single crystal. As a result of diligent study to improve the transparency of the AlₓGa₍₁₋ₓ₎N single crystal, the inventors found out that the transparency of the AlₓGa(₁₋ₓ₎ N single crystal is relative to the oxygen concentration and dislocation density. The grounds are set forth below.

The O (oxygen) atom contained in the AlₓGa₍₁₋ₓ₎N single crystal is substituted with N (nitrogen) atom to become substituted oxygen atom O_{N}, and bonded with the lattice defect (vacancy-type defect V_{Al}) of Al (aluminium) atom to constitute a combined defect V_{Al} - ON. This combined defect V_{Al} - O_{N} forms a dipole moment. When the AlₓGa₍₁₋ₓ₎N single crystal is irradiated with ultraviolet ray, it is rendered active to form an absorption level in the band gap. By lowering the absorption level, the absorption coefficient in the ultraviolet range to deep ultraviolet range can be reduced.

Thus, a method of producing an AlₓGa₍₁₋ₓ₎N single crystal of the present invention is directed to growing an AlₓGa₍₁₋ₓ₎N (0 < x ≤ 1) single crystal by sublimation, and includes the steps set forth below. An underlying substrate having a composition ratio x identical to that of the AlₓGa₍₁₋ₓ₎N single crystal is prepared. A material of high purity is prepared. The raw material is sublimated to grown an AlₓGa₍₁₋ₓ₎N single crystal on the underlying substrate.

Since an underlying substrate of a composition identical to that of the AlₓGa₍₁₋ₓ₎N single crystal to be grown is employed in the method of producing an AlₓGa₍₁₋ₓ₎N single crystal of the present invention, the crystallinity of the growing AlₓGa₍₁₋ₓ₎N single crystal can be rendered favorable. Further, since an AlₓGa₍₁₋ₓ₎N single crystal is grown from a raw material of high purity, impurities such as oxygen included in the AlₓGa₍₁₋ₓ₎N single crystal can be reduced. Therefore, an AlₓGa₍₁₋ₓ₎N single crystal of high purity, having favorable crystallinity, can be grown. The inventors found out that the combined defect V_{Al}-O_{N} can be reduced as the oxygen concentration and dislocation density are lower. Therefore, since the combined defect V_{Al}-O_{N} can be reduced, the absorption level greater than or equal to 250 nm and less than 350 nm in the band gap associated with a combined defect V_{Al}-O_{N} can be reduced. As a result, the absorption coefficient to light at a wavelength greater than or equal to 250 nm and less than 350 nm can be reduced, as set forth above. Therefore, an AlₓGa₍₁₋ₓ₎N single crystal improved in the transparency at the ultraviolet range to deep ultraviolet range can be produced.

As used herein, "raw material of high purity" means that the impurity concentration in the raw material is less than or equal to 0.04 wt%, preferably less than or equal to 0.025 wt%, and further preferably less than or equal to 0.01 wt%, under thermal desorption spectroscopy or the like. In other words, the impurities in the raw material correspond to the case where impurities are included not intentionally, but only inevitably, and the case where impurities less than or equal to 0.04 wt% are included.

Preferably in the method of producing an AlₓGa₍₁₋ₓ₎N single crystal set forth above, the step of growing includes the step of growing an AlxGa₍₁₋ₓ₎N single crystal having a thickness greater than or equal to 300 µm.

The inventors of the present invention found out that, when an AlₓGa₍₁₋ₓ₎N single crystal is grown thick, the dislocation density generated at the grown AlₓGa₍₁₋ₓ₎N single crystal can be reduced. The inventors found out that the dislocation density can be reduced effectively by particularly growing an AlₓGa₍₁₋ₓ₎N single crystal having a thickness greater than or equal to 300 µm. Therefore, an AlₓGa₍₁₋ₓ₎N single crystal having the absorption coefficient further reduced can be grown. Accordingly, the transparency can be further improved.

The AlₓGa₍₁₋ₓ₎N single crystal (0 < x ≤ 1) according to an aspect of the present invention is characterized in that the absorption coefficient with respect to light at a wavelength greater than or equal to 250 nm and less than 300 nm is less than or equal to 100 cm⁻¹ , measured at 300K.

The AlₓGa₍₁₋ₓ₎N (0 < x ≤ 1) according to another aspect of the present invention is characterized in that the absorption coefficient with respect to light at the wavelength greater than or equal to 300 nm and less than 350 nm is less than or equal to 21 cm⁻¹, measured at 300K.

According to the AlₓGa₍₁₋ₓ₎N single crystal of the one and another aspect of the present invention, an AlₓGa₍₁₋ₓ₎N single crystal having the impurity concentration and dislocation density reduced can be produced through the method of producing an AlₓGa₍₁₋ₓ₎N single crystal of the present invention set forth above. Accordingly, an AlₓGa₍₁₋ₓ₎N single crystal having the aforementioned low absorption coefficient can be obtained. Thus, an AlₓGa₍₁₋ₓ₎N single crystal improved in transparency can be implemented.

The AlₓGa₍₁₋ₓ₎N single crystal set forth above is preferably characterized in that the dislocation density is less than or equal to 1.3 × 10⁵cm⁻²

Accordingly, the absorption coefficient can be further lowered since the combined defect V_{Al} - ON can be further reduced. Thus, the transparency can be further improved.

The AlₓGa₍₁₋ₓ₎N single crystal set forth above is preferably characterized in that the oxygen concentration is less than or equal to 5.8 × 10¹⁷cm⁻³.

Accordingly, reducing the substituted oxygen atom ON allows further reduction of the combined defect V_{Al} - ON. Since the absorption coefficient can be further reduced, the transparency can be further improved.

The AlₓGa₍₁₋ₓ₎N single crystal set forth above is preferably characterized in including a main surface having a surface roughness RMS less than or equal to 100 nm.

Accordingly, light reflectance at the main surface of the AlₓGa₍₁₋ₓ₎N single crystal can be reduced, allowing further improvement of the transparency to light at the wavelength set forth above.

The AlₓGa₍₁₋ₓ₎N single crystal preferably is characterized in having a width or diameter greater than or equal to 5 mm, and a thickness greater than or equal to 300 µm.

Thus, the size and strength required for an optical component can be maintained Since the dislocation density can be reduced effectively by taking a thickness greater than or equal to 300 µm, the absorption coefficient can be further reduced. Thus, the transparency can be further improved.

An optical component of the present invention is fabricated using the AlₓGa₍₁₋ₓ₎N single crystal set forth above.

Since the optical component of the present invention employs an AlₓGa₍₁₋ₓ₎N single crystal having the transparency improved, an optical lens improved in performance can be implemented.

### EFFECTS OF THE INVENTION

According to an AlₓGa₍₁₋ₓ₎N single crystal, a method of producing an AlₓGa₍₁₋ₓ₎N single crystal, and an optical component of the present invention, an AlₓGa₍₁₋ₓ₎N single crystal improved in the transparency at an ultraviolet range to a deep ultraviolet range can be implemented.

### BRIEF DESCRIPTION OF THE DRAWINGS

Fig. 1 is a schematic sectional view of an AlₓGa₍₁₋ₓ₎N single crystal according to a first embodiment of the present invention.
Fig. 2 is a flowchart representing a method of producing an AlₓGa₍₁₋ₓ₎N single crystal according to the first embodiment of the present invention.
Fig. 3 represents a deposition apparatus that can be used in the production of an AlₓGa₍₁₋ₓ₎N single crystal according to the first embodiment of the present invention.
Fig. 4 is a schematic sectional view representing an underlying substrate according to the first embodiment of the present invention.
Fig. 5 is a schematic sectional view representing a grown state of an AlₓGa₍₁₋ₓ₎N single crystal according to the first embodiment of the present invention.
Fig. 6 is a schematic perspective view of an optical component according to a second embodiment of the present invention.
Fig. 7 is a schematic perspective view of an optical component according to a modification of the second embodiment of the present invention.
Fig. 8 is a flowchart representing a method of fabricating an optical component according to the second embodiment of the present invention.

### MODES FOR CARRYING OUT THE INVENTION

Embodiments of the present invention will be described hereinafter with reference to the drawings. In the drawings, the same or corresponding elements have the same reference characters allotted, and description thereof will not be repeated.

### (First Embodiment)

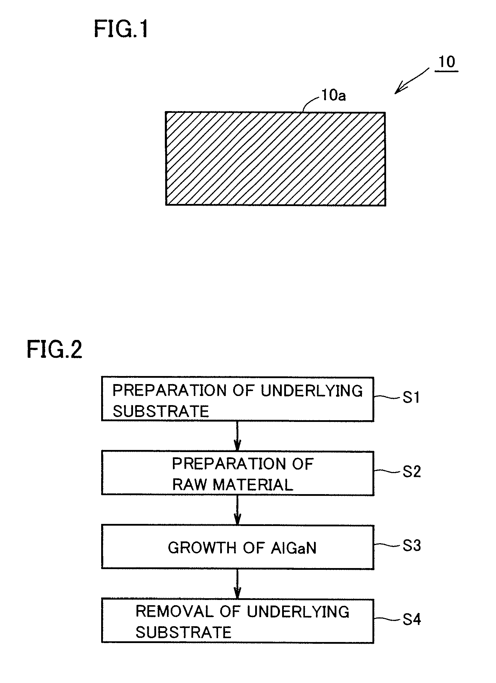

Fig. 1 is a schematic sectional view of an AlₓGa₍₁₋ₓ₎N (0 < x ≤1) single crystal according to the present embodiment. With reference to Fig. 1, an AlₓGa₍₁₋ₓ₎N single crystal of the present embodiment will be first described. The composition ratio x is the mole ratio of Al and Ga.

As shown in Fig. 1, an AlₓGa₍₁₋ₓ₎N single crystal 10 includes a main surface 10a. From the standpoint of a size feasible for machining into an optical component and having mechanical strength, AlₓGa₍₁₋ₓ₎N single crystal 10 preferably has a width or diameter greater than or equal to 5 mm and a thickness greater than or equal to 300 µm. From a similar standpoint, AlₓGa ₍₁₋ₓ₎N single crystal 10 preferably has a width or diameter greater than or equal to 10 mm and a thickness greater than or equal to 1000 µm.

As used herein, the width of AlₓGa₍₁₋ₓ₎N single crystal 10 implies the distance between two top points specified arbitrarily, opposite to each other at main surface 10a with the center therebetween, when main surface 10a of the single crystal is polygonal. The diameter of AlₓGa₍₁₋ₓ₎N single crystal 10 implies the longest length of a diameter specified arbitrarily at main surface 10a, when main surface 10a of the single crystal is circular or elliptical.

Since main surface 10a of AlₓGa₍₁₋ₓ₎N single crystal 10 can reduce the reflectance of light therefrom, surface roughness RMS is preferably less than or equal to 100 nm, more preferably less than or equal to 10 nm, and further preferably 1 nm, from the standpoint of further improving the transparency.

As used herein, surface roughness RMS implies the square average roughness of the surface defined at JIS B0601, i.e. the root mean square average of the distance from the average plane to the measurement plane (deviation).

The absorption coefficient of AlₓGa₍₁₋ₓ₎N single crystal 10 with respect to light at a wavelength greater than or equal to 300 nm and less than 350 nm is less than or equal to 21 cm⁻¹, preferably less than or equal to 15 cm⁻¹, more preferably less than or equal to 5 cm⁻¹, and most preferably less than or equal to 3 cm⁻¹, measured at 300K. In the case of these absorption coefficients, the transparency to light greater than or equal to 300 nm and less than 350 nm can be improved.

The absorption coefficient of AlₓGa₍₁₋ₓ₎N single crystal 10 with respect to light at a wavelength greater than or equal to 250 nm and less than 300 nm is less than or equal to 100 cm⁻¹, preferably less than or equal to 50 cm⁻¹, more preferably less than or equal to 10 cm⁻¹, and most preferably less than or equal to 8.6 cm⁻¹, measured at 300K. In the case of these absorption coefficients, the transparency to light greater than or equal to 250 nm and less than 300 nm can be improved.

The "absorption coefficient" is a value calculated from the thickness of AlₓGa₍₁₋ₓ₎N single crystal 10 by measuring the transmittance through, for example, an ultraviolet-visible spectrophotometer.

The dislocation density of Alₓ₍₁₋ₓ₎N single crystal 10 is preferably less than or equal to 1.3 × 10⁵cm⁻², more preferably less than or equal to 9.0 × 10⁴cm⁻², and most preferably less than or equal to 4.0 × 10⁴cm⁻², from the standpoint of reducing the absorption coefficient since any combined defect V_{Al} - O_{N} can be further reduced.

The "dislocation density" is a value measured by, for example, the EPD (etch pit) method. In the EPD method, the number of pits caused by etching in, for example, KOH (potassium hydroxide) melt is counted and divided by the unit area.

The oxygen concentration of AlₓGa₍₁₋ₓ₎N single crystal 10 is preferably less than or equal to 5.8 × 10¹⁷cm⁻³, more preferably less than or equal to 5.2 × 10¹⁷cm⁻³, and most preferably less than or equal to 5.1 × 10¹⁷cm⁻³, from the standpoint of reducing the absorption coefficient by further reducing any combined defect V_{Al} - O_{N}.

The "oxygen concentration" is a value measured by analysis based on, for example, SIMS (secondary ion mass spectroscopy).

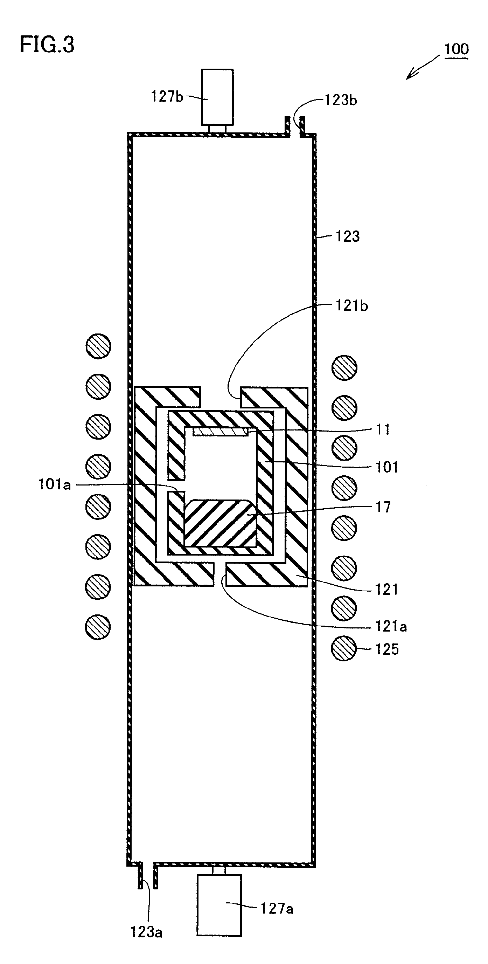

Next, a method of producing an AlₓGa₍₁₋ₓ₎N single crystal of the present embodiment will be described hereinafter with reference to Figs. 2 and 3 Fig. 2 is a flowchart representing a method of producing an AlₓGa₍₁₋ₓ₎N single crystal of the present embodiment. Fig. 3 represents a deposition apparatus that can be used in the production of an Alₓ₍₁₋ₓ₎N single crystal in the present embodiment.

With reference to Fig. 3, the main structure of a deposition apparatus 100 of the present embodiment will be described. Deposition apparatus 100 is a device for crystal growth based on sublimation.

Referring to Fig. 3, deposition apparatus 100 mainly includes a crucible 101, a heat body 121, a reaction vessel 123, and a heater 125.

Crucible 101 includes an outlet 101a. Heat body 121 is provided around crucible 101 in a manner ensuring communication into and out from crucible 101. Reaction vessel 123 is located around heat body 121. At the outside center region of reaction vessel 123, heater 125 such as a high frequency heating coil is arranged to heat up heat body 121.

At respective one ends of heat body 121 and reaction vessel 123 are provided inlets 121a and 123a, respectively, to allow carrier gas such as nitrogen gas to flow into crucible 101 disposed in reaction vessel 123. At respective other ends of heat body 121 and reaction vessel 123 are provided outlets 121b and 123b, respectively, to allow carrier gas to be output from reaction vessel 123. Furthermore, radiation thermometers 127a and 127b are provided above and below reaction vessel 123, respectively, to measure the temperature above and below crucible 101.

Deposition apparatus 100 may include various elements other than those described above. For the sake of convenience, such other elements are not depicted.

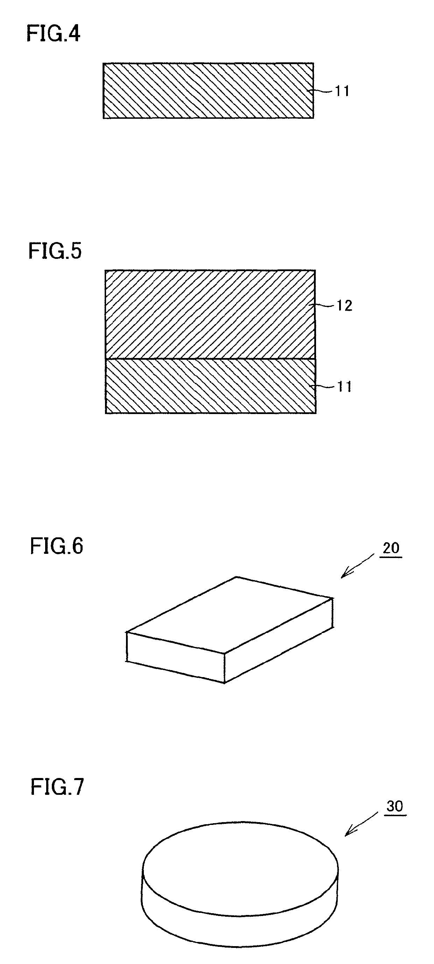

Fig. 4 is a schematic sectional view of an underlying substrate of the present embodiment. As shown in Figs. 2-4, an underlying substrate 11 is prepared (step S1). The underlying substrate has a composition ratio x identical to that of AlₓGa₍₁₋ₓ₎N single crystal 12 to be grown (refer to Fig. 5). Underlying substrate 11 is set at the upper region of crucible 101.

Then, a raw material 17 of high purity is prepared (step S2). The impurity concentration of raw material 17 is less than or equal to 0.04 wt%, preferably less than or equal to 0.025 wt% , and further preferably less than or equal to 0.01 wt%. Raw material 17 does not include sintering aids. Raw material 17 is located at the lower region of crucible 101, facing underlying substrate 11.

Fig. 5 is a schematic sectional view of an AlₓGa₍₁₋ₓ₎N single crystal in a grown state of the present embodiment. As shown in Fig. 5, raw material 17 is sublimated to grow an AlₓGa₍₁₋ₓ₎N single crystal 12 on underlying substrate 11 (step S3). At step S3, AlₓGa ₍₁₋ₓ₎N single crystal 12 is grown by sublimation.

Specifically, raw material 17 is heated by heater 125 up to the sublimation temperature of raw material 17. The heating causes sublimation of raw material 17 to generate sublimation gas. The sublimation gas is solidified at the surface of underlying substrate 11 set at a temperature lower than that of raw material 17. Accordingly, AlₓGa₍₁₋ₓ₎N single crystal 12 is grown on underlying substrate 11. This AlₓGa₍₁₋ₓ₎N single crystal 12 has the above-described low absorption coefficient.

Then, underlying substrate 11 is removed (step S4). This step S4 may be omitted. When to be removed, only underlying substrate 11, or underlying substrate 11 as well as a portion of AlₓG₍₁₋ₓ₎N single crystal 12, may be removed.

The method of removing is not particularly limited. For example, a mechanical way such as cutting, grinding, or cleavage may be employed. Cutting refers to removing at least underlying substrate 11 from AlₓGa₍₁₋ₓ₎N single crystal 12 by means of machinery such as a slicer or the like having a peripheral cutting edge of a diamond electrodeposition wheel. Grinding refers to grinding off the surface in the thickness direction by bringing a grindstone into contact with the surface while rotating. Cleavage refers to dividing AlₓGa₍₁₋ₓ₎N single crystal 12 along a crystallite lattice plane. A chemical removing method such as etching may also be employed.

Then, both faces of AlₓG₍₁₋ₓ₎N single crystal 12 are rendered flat by grinding, polishing, and the like. This AlₓGa₍₁₋ₓ₎N single crystal 12 can have its surface rendered flat readily since chaffing during polishing can be suppressed. Although the aforementioned grinding/polishing is dispensable, AlₓGa₍₁₋ₓ₎N single crystal 12 is preferably rendered flat such that surface roughness RMS is less than or equal to 100 nm.

When an AlₓGa₍₁₋ₓ₎N single crystal 12 having a thickness greater than or equal to 30 mm, for example, is grown, a plurality of AlₓGa₍₁₋ₓ₎N single crystals 10 can be cut out from AlₓGa₍₁₋ₓ₎N single crystal 12. Since AlₓGa₍₁₋ₓ₎N single crystal 12 is monocrystalline, the dividing is feasible. In this case, AlₓGa₍₁₋ₓ₎N single crystal 12 has favorable crystallinity, and allows reduction in the production cost.

By carrying out steps S1-S4 set forth above, an AlₓGa₍₁₋ₓ₎N single crystal 10 can be produced.

AlₓGa₍₁₋ₓ₎N single crystal 10 produced as set forth above has low absorption with respect to light in the range of ultraviolet to deep ultraviolet range. Moreover, AlₓGa₍₁₋ₓ₎N single crystal 10 can be readily machined by virtue of its property, and allows improvement in corrosion resistance against halogen gas and the like.

Since AlₓGa₍₁₋ₓ₎N single crystal 10 is monocrystalline, there is almost no grain boundary such as of polycrystalline, and chaffing during grinding and polishing can be suppressed. Therefore, the loss in light transmittance can be reduced. Further, reflection of light from main surface 10a can be suppressed. Thus, the light transparency of AlₓGa₍₁₋ₓ₎N single crystal 10 can be improved.

Further, AlₓGa₍₁₋ₓ₎N single crystal 10 is absent of impurities such as sintering aids required for a sintering body, due to the high purity of raw material 17. Therefore, AlₓGa₍₁₋ₓ₎N single crystal 10 has higher heat conductivity than a sintered body and polycrystalline AlₓG₍₁₋ₓ₎N, allowing variation in the rate of thermal expansion to be suppressed. Thus, the thermal shock resistance can be improved.

Moreover, a thick AlₓGa₍₁₋ₓ₎N single crystal 10 can be obtained since it is grown by sublimation. Therefore, the strength of AlₓGa₍₁₋ₓ₎N single crystal 10 can be improved.

Therefore, AlₓGa₍₁₋ₓ₎N single crystal 10 of the present embodiment is suitable for usage as the window member of a light emitting device such as LEDs and LDs in the ultraviolet range to deep ultraviolet range using nitride semiconductor, employed in arc tubes of high-pressure discharge lamps, in sterilization and medical treatment, biochips, as well as high density DVDs of the next generation, and also as a window member employed in a light receiving device such as an ultraviolet detector typified by fire sensors.

### (Second Embodiment)

Fig. 6 is a schematic perspective view of an optical component of the present embodiment. An optical component 20 of the present embodiment will be described hereinafter with reference to Fig. 6. Optical component 20 is fabricated using AlₓGa₍₁₋ₓ)N single crystal 10 described in the first embodiment. As shown in Fig. 6, optical component 20 takes a rectangular plate shape in plan view.

Fig. 7 is a schematic perspective view of an optical component according to a modification of the present embodiment. Referring to Fig. 7, an optical component 30 of the modification takes a circular plate shape in plan view.

Optical component 20, 30 is window member of a light emitting device such as LEDs and LDs in the ultraviolet range to deep ultraviolet range using nitride semiconductor, employed in arc tubes of high-pressure discharge lamps, in sterilization and medical treatment, biochips, as well as high density DVDs of the next generation, or a window member employed in a light receiving device such as an ultraviolet detector typified by fire sensors.

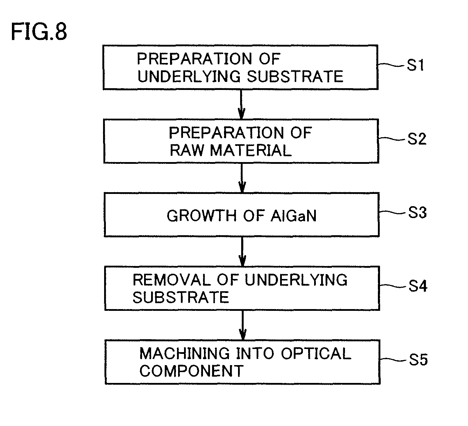

A method of fabricating optical component 20, 30 of the present embodiment will be described hereinafter with reference to Figs. 6-8. Fig. 8 is a flowchart representing the method of fabricating optical component 20, 30 of the present embodiment.

As shown in Fig. 8, first an AlₓGa₍₁₋ₓ₎N single crystal 10 of the first embodiment is fabricated as set forth above (steps S1-S4).

Then, an optical component is fabricated using AlₓGa₍₁₋ₓ₎N single crystal 10 (step S5). At this step S5, AlₓGa₍₁₋ₓ₎N single crystal 10 is machined into optical component 20 of Fig. 6/optical component 30 of Fig. 7. The machining method can be carried out by, but not particularly limited to, polishing, grinding, or the like.

Since AlₓGa₍₁₋ₓ₎N single crystal 10 has a hardness feasible for machining, AlₓGa₍₁₋ₓ)N single crystal can be readily machined to the configuration set forth above at step S5.

Although the present embodiment has been described based on an optical component of a plate shape, the present invention is not limited thereto. The desired configuration may be applied.

### EXAMPLE

A method of producing an AlₓGa₍₁₋ₓ₎N single crystal 10 having an absorption coefficient less than or equal to 100 cm⁻¹ with respect to light at a wavelength greater than or equal to 250 nm and less than 300 nm, and an absorption coefficient less than or equal to 21 cm⁻¹ with respect to light at a wavelength greater than or equal to 300 nm and less than 350 nm was evaluated. Specifically, an AlₓGa₍₁₋ₓ₎N single crystal 10 was produced according to the method of producing an AlₓGa₍₁₋ₓ₎N single crystal 12 of the first embodiment.

### (Examples 1-4)

As underlying substrate 11, an AlN substrate having a diameter of 12 mm or 2 inches set forth in Table 1 below was prepared (step S1). This underlying substrate 11 was set at an upper region of crucible 101 made of WC. At this stage, underlying substrate 11 was firmly attached to a lid formed of a substance identical to that of crucible 101.

Then, raw material 17 of high purity was prepared (step S2). At step S2, impurities were reduced by first heating the prepared raw material to a temperature greater than or equal to 1500°C and less than or equal to 2000°C to obtain raw material 17 of high purity. Thus, an AlN sintered raw material having an impurity concentration of 0.025 wt% was prepared in Examples 1-3. Also, an AlN sintered raw material having an impurity concentration of 0.040 wt% was prepared in Example 4. This raw material 17 was arranged to face underlying substrate 11.

Then, AlₓGa₍₁₋ₓ₎N single crystal 12 was grown (step S3). Specifically, the following steps were carried out.

N₂ gas was introduced into reaction vessel 123, and the temperature in crucible 101 was raised by means of a high frequency heating coil identified as heater 125 while controlling the amount of introduced N₂ gas and the output of N₂ such that the partial pressure of N₂ gas was 10 kPa to 100 kPa. Subsequent to radiation thermometer 127a measuring the temperature of crucible 101 at the raw material 17 side indicating a value reaching a defined level, power was controlled such that the N₂ gas partial pressure, the measured temperature by radiation thermometer 127a at the raw material 17 side, and the temperature by radiation thermometer 127b at the underlying substrate 11 side were set forth in Table 1 below. Accordingly, AlN was sublimated from raw material 17 over a deposition period of 40 hours. An AlN single crystal identified as AlₓGa₍₁₋ₓ₎N single crystal 12 was grown on underlying substrate 11. Following the cooling down to room temperature, the AlN single crystal was taken out from crucible 101.

The size of this AlN single crystal was substantially identical to underlying substrate 11, and had a thickness set forth in Table 1 below. Further, the growth rate was as set forth in Table 1.

Then, the underlying substrate was removed (step S4). Specifically, the obtained AlN single crystal was sliced parallel to the (0001) plane to remove underlying substrate 11, and a plurality of sheets of the substrate (AlN single crystal substrate) were obtained. Then, both faces of the AlN single crystal substrate were rendered flat by grinding The surface was further polished by diamond abrasive processing. Thus, an AlN single crystal substrate identified as AlₓGa₍₁₋ₓ₎N single crystal 10 of Examples 1-4 was produced.

### (Comparative Example 1)

Comparative Example 1 is based on a structure basically similar to that of Example 4, differing in that an SiC substrate was prepared as underlying substrate 11. The remaining conditions were as set forth in Table 1 below.

### (Comparative Example 2)

Comparative Example 2 is based on a structure basically similar to that of Examples 1-3, differing in that an AlN sintered raw material having the impurity concentration of 0.050 wt% for the raw material was prepared. The remaining conditions were as shown in Table 1 below.

### (Measurement Method)

The AlN single crystal substrate of Examples 1-4 and Comparative Examples 1 and 2 had the absorption coefficient, dislocation density, oxygen concentration, surface roughness RMS and FWHM (Full Width at Half Maximum: rocking curve half-width by X-ray diffraction) measured as set forth below. The results are indicated in Table 1 below.

Absorption Coefficient: The transmittance was measured with an ultraviolet-visible spectrophotometer, and the absorption coefficient was calculated by the thickness of the AlN single crystal substrate.

Dislocation Density: Calculated by the EPD method. Specifically, the AlN single crystal substrate was immersed for 30 minutes in a melt to be etched. This melt was KOH:NaOH (sodium hydroxide) at the ratio of 1:1, melted at 250°C in a platinum crucible. Then, the AlN single crystal substrate was rinsed, and the number of etch pits per unit area generated at the surface was counted through a microscope.

Oxygen Concentration: Using a 5 mm square specimen (a square region of 5 mm × 5 mm) cut out from the center of the AlN single crystal substrate, the oxygen concentration was measured by SIMS.

Surface Roughness RMS: Measured according to JIS B0601. Specifically, the surface roughness RMS at the face of the AlN single crystal substrate corresponding to the Al face side was measured within the field of view of 50 µm square (square region of 50 µm × 50 µm), using an AFM (atomic force microscope).

FWHM: The X-ray diffraction peak was measured for the (0002) plane at the flat portion of the uppermost AlN single crystal substrate.

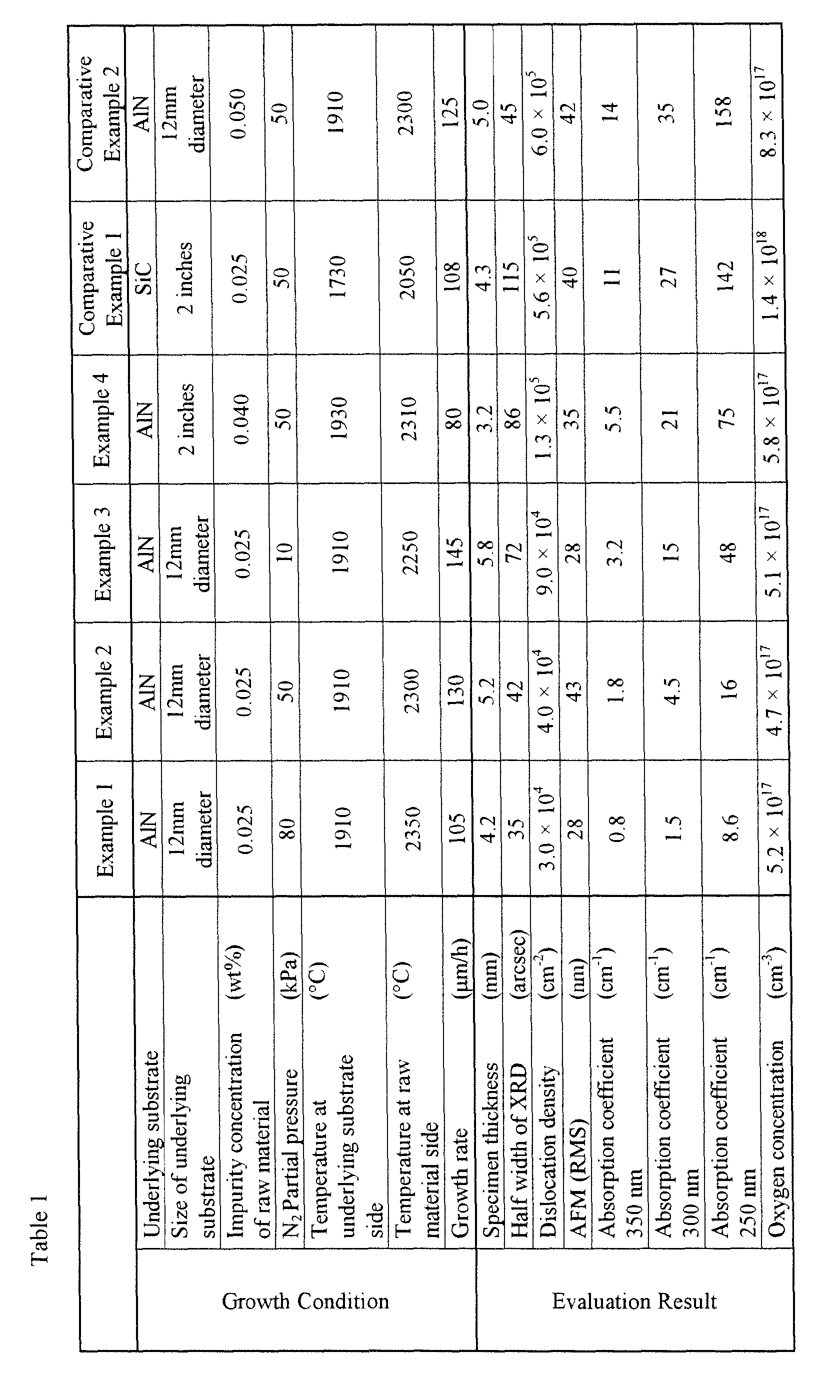

### (Measurement Result)

The AlN single crystal substrate of Examples 1-4 exhibited an extremely low absorption coefficient; the absorption coefficient with respect to light at a wavelength greater than or equal to 300 nm and less than350 nm was less than or equal to 21 cm⁻¹, and the absorption coefficient with respect to light at a wavelength greater than or equal to 250 nm and less than 300 nm was less than or equal to 75 cm⁻¹.

The AlN single crystal substrate of Examples 1-4 also exhibited a low dislocation density and a low oxygen concentration of less than or equal to 1.3 × 10⁵ cm⁻², and less than or equal to 5.8 × 10¹⁷ cm⁻³, respectively. Further, the AlN single crystal substrate of Examples 1-4 had a small surface roughness RMS of 43 nm. Moreover, the FWHM of the AlN single crystal substrate of Examples 1-4 was small, i.e. less than or equal to 86 arcsec, indicating a crystal of high quality.

In contrast, the AlN single crystal substrate of Comparative Example 1 could not have the dislocation density reduced sufficiently since it was produced by deposition on a substrate of a different type. Accordingly, the absorption coefficient with respect to light at the wavelength of 250 nm and 300 nm was high.

The AlN single crystal substrate of Comparative Example 2 had a high concentration of oxygen, identified as impurities, due to the high purity of the raw material. Accordingly, the absorption coefficient with respect to light at the wavelength of 250 nm and 300 nm was high.

Thus, in accordance with the present examples, it was confirmed that an AlₓGa₍₁₋ₓ₎N single crystal having a low absorption coefficient less than or equal to 100 cm⁻¹ with respect to light at a wavelength greater than or equal to 250 nm and less than 300 nm, and a low absorption coefficient less than or equal to 21 cm⁻¹ with respect to light at a wavelength greater than or equal to 300 nm and less than 350 nm could be implemented, by rendering the purity of the raw material high, and employing an underlying substrate of a composition identical to that of AlₓG₍₁₋ₓ₎N single crystal to be grown.

Then, using the AlₓGa₍₁₋ₓ₎N single crystal obtained in Examples 1-4 and Comparative Examples 1-2, an optical component having a rectangular planar shape as shown in Fig. 6, and an optical component having a circular planar shape as shown in Fig. 7 were fabricated, as set forth in Table 2 below by a well-known method. The transparency of the optical components of Examples 1-4 and Comparative Examples 1-2 was measured. The transparency was evaluated by the ratio of transmittance of incident light to the optical component. The results are shown in Table 2 below. Table 2 represents the groups of A, B, and C in the order of higher transparency. The optical component in the group with highest transparency was A, the optical component in the group with the lowest transparency was C, and the optical component in the group with transparency between A and C was B. The optical components in the groups of A and B had superior transparency.

**Table 2**

| | Example 1 | Example 2 | Example 3 | Example 4 | Comparative Example 1 | Comparative Example 2 |
|---|---|---|---|---|---|---|
| Shape | Fig. 6 | Fig.7 | Fig. 6 | Fig. 7 | Fig. 6 | Fig.7 |
| Transparency | A | A | B | B | C | C |

It is appreciated from Table 2 that an optical component exhibiting particularly high transparency was obtained from the AlₓGa₍₁₋ₓ₎N single crystal of Examples 1 and 2. An optical component having high transparency was also obtained from the AlₓGa₍₁₋ₓ₎N single crystal of Examples 3 and 4. This is probably attributed to the high transmittance of the AlₓGa₍₁₋ₓ₎N single crystal. Other possible contributing factors include the low dislocation density and low oxygen concentration of the AlₓGa₍₁₋ₓ₎N single crystal.

In contrast, the optical component fabricated using the AlₓGa₍₁₋ₓ₎N single crystal of Comparative Examples 1 and 2 exhibited low transparency.

According to the examples of the present invention, it was confirmed that an optical component having improved transparency can be implemented by fabricating the optical component using an AlₓGa₍₁₋ₓ₎N single crystal having a low absorption coefficient less than or equal to 100 cm⁻¹ with respect to light at a wavelength greater than or equal to 250 nm and less than 300 nm, and a low absorption coefficient less than or equal to 21 cm⁻¹ with respect to light at a wavelength greater than or equal to 300 nm and less than 350 nm.

It should be understood that the embodiments and examples disclosed herein are illustrative and non-restrictive in every respect. The scope of the present invention is defined by the appended claims, rather than the description set forth above, and all changes that fall within limits and bounds of the claims, or equivalence thereof are intended to be embraced by the claims.

### Description of Reference Characters

10, 12 AlₓGa ₍₁₋ₓ₎N single crystal, 10a main surface, 11 underlying substrate, 17 raw material, 20, 30 optical component, 100 deposition apparatus, 101 crucible, 101a outlet, 121 heat body, 121a, 123a inlet, 121b, 123b outlet, 123 reaction vessel, 125 heater, 127a, 127b radiation thermometer.

## Claims

1. A method of producing an AlₓGa₍₁₋ₓ₎N single crystal (10), said Alₓ₍₁₋ₓ₎N (0 < x ≤1) single crystal (10, 12) being grown by sublimation, said method comprising the steps of:
preparing an underlying substrate (11) having a composition ratio x identical to the composition ratio of said AlₓGa₍₁₋ₓ₎N single crystal (10, 12),
preparing a raw material (17) of high purity, and
growing said AlₓGa₍₁₋ₓ₎N single crystal (10, 12) on said underlying substrate (11) by sublimating said raw material (17)

2. The method of producing an AlₓGa₍₁₋ₓ₎N single crystal (10) according to claim 1, wherein said step of growing includes the step of growing said AlₓGa₍₁₋ₓ₎N single crystal (10, 12) having a thickness greater than or equal to 300 µm.

3. An AlₓGa₍₁₋ₓ₎N (0 < x ≤ 1) single crystal (10), having an absorption coefficient less than or equal to 100cm⁻¹ with respect to light at a wavelength greater than or equal to 250 nm and less than 300 nm, measured at 300K.

4. An AlₓGa₍₁₋ₓ₎N (0 < x ≤ 1) single crystal (10), having an absorption coefficient less than or equal to 21 cm⁻¹ with respect to light at a wavelength greater than or equal to 300 nm and less than 350 nm, measured at 300K.

5. The AlₓGa₍₁₋ₓ₎N single crystal (10) according to claim 3, wherein a dislocation density is less than or equal to 1.3 × 10⁵cm⁻²

6. The AlₓGa₍₁₋ₓ₎N single crystal (10) according to claim 3, wherein an oxygen concentration is less than or equal to 5.8 × 10¹⁷cm⁻³.

7. The AlₓGa₍₁₋ₓ₎N single crystal (10) according to claim 3, including a main surface (10a) having a surface roughness RMS less than or equal to 100 nm.

8. The AlₓGa₍₁₋ₓ₎N single crystal (10) according to claim 3, wherein a width or a diameter is greater than or equal to 5 mm, and a thickness is greater than or equal to 300 µm.

9. An optical component (20, 30) fabricated using the AlₓGa₍₁₋ₓ₎N single crystal (10) set forth in claim 3.
